# DEMANDE DE BREVET EUROPEEN

(11) **EP 4 766 104 A1**
(43) Date de publication de la demande: **24.06.2026**
(21) Numéro de dépôt: 25221618.9
(22) Date de dépôt: 09.12.2025
(51) Int. Cl.: H10H 20/01, H10H 29/01, H10H 29/14, H10H 20/819, H10H 20/825, H10H 29/80

(54) **PROCÉDÉ DE RÉALISATION D'UN DISPOSITIF OPTO-ÉLECTRONIQUE**

(30) Priorité: 17.12.2024 FR 2414283
(71) Demandeur: Commissariat à l'Energie Atomique et aux Energies Alternatives, 75015 Paris (FR)
(72) Inventeur: PERNEL, Carole, 38054 GRENOBLE CEDEX 09 (FR); TORRENGO, Simona, 38054 GRENOBLE CEDEX 09 (FR); SIMON, Julia, 38054 GRENOBLE CEDEX 09 (FR)
(74) Mandataire: Cabinet Beaumont

(57) **Abrégé**

La présente description concerne un procédé de réalisation d'un dispositif opto-électronique, le procédé comprenant les étapes successives suivantes :

a) former, sur un substrat de support (153), un empilement d'électropolissage (157) comprenant :

- une première couche (163) semiconductrice sacrificielle ;

- une deuxième couche (159) semiconductrice de transport de charges ; et

- une troisième couche (161) semiconductrice de protection de la deuxième couche (159), la troisième couche (161) étant interposée entre les première (163) et deuxième (159) couches et présentant un niveau de dopage strictement inférieur à ceux des première (163) et deuxième (159) couches ;

b) former, du côté d'une face de l'empilement d'électropolissage (157) opposée au substrat de support (153), un empilement actif (165) de diode au nitrure de gallium ; et

c) retirer le substrat de support (153) par électropolissage de la première couche (163) en appliquant, entre une électrode en contact mécanique avec la deuxième (159) ou la troisième (161) couche et une contre-électrode disposée dans une solution électrolytique, un courant de polarisation traversant, dans cet ordre, les deuxième (159), troisième (161) et première (163) couches.

## Description

### Domaine technique

La présente description concerne de façon générale les dispositifs opto-électroniques. Elle vise plus particulièrement des dispositifs opto-électroniques comportant une pluralité de diodes au nitrure de gallium et un circuit de contrôle de ces diodes, ainsi que des procédés de réalisation de tels dispositifs.

### Technique antérieure

Des dispositifs opto-électroniques comportant une pluralité de diodes au nitrure de gallium, par exemple des diodes électroluminescentes (LED) au nitrure de gallium, et un circuit de contrôle de ces diodes ont été proposés. Des procédés de réalisation de tels dispositifs ont en outre été proposés.

Selon une approche, un empilement actif de diode est formé sur un premier substrat de support, par exemple en silicium, revêtu d'une ou plusieurs couches tampon de croissance de l'empilement actif de diode. L'empilement actif de diode est ensuite reporté sur un deuxième substrat dans et sur lequel a préalablement été réalisé le circuit de contrôle. Le premier substrat est alors retiré, par exemple par meulage du silicium du premier substrat puis amincissement de la ou des couches tampon de croissance par gravure sèche. La pluralité de diodes est ensuite formée à partir de l'empilement actif de diode. Selon une autre approche, la pluralité de diodes est formée à partir de l'empilement actif de diode préalablement à l'étape de report sur le deuxième substrat.

Toutefois, les dispositifs opto-électroniques existants et les procédés existants de réalisation de tels dispositifs souffrent de divers inconvénients. Par exemple, l'étape de retrait du substrat de support comporte des risques d'endommagement de l'empilement actif de diode ou de la pluralité de diodes, en fonction de l'approche considérée. En particulier, l'amincissement des couches tampon par gravure sèche entraîne des non-uniformités d'épaisseur du dispositif final, ce qui impacte fortement le contrôle de ses performances optiques.

### Résumé de l'invention

Il existe un besoin d'améliorer les dispositifs opto-électroniques existants comportant une pluralité de diodes au nitrure de gallium et un circuit de contrôle de ces diodes. Il existe en outre un besoin de pallier tout ou partie des inconvénients des procédés existants de réalisation de tels dispositifs.

Pour cela, un mode de réalisation prévoit un procédé de réalisation d'un dispositif opto-électronique, le procédé comprenant les étapes successives suivantes :
a) former, sur un substrat de support, un empilement d'électropolissage comprenant :
   - une première couche semiconductrice sacrificielle ;
   - une deuxième couche semiconductrice de transport de charges ; et
   - une troisième couche semiconductrice de protection de la deuxième couche, la troisième couche étant interposée entre les première et deuxième couches et présentant un niveau de dopage strictement inférieur à ceux des première et deuxième couches ;
b) former, du côté d'une face de l'empilement d'électropolissage opposée au substrat de support, un empilement actif de diode au nitrure de gallium ; et
c) retirer le substrat de support par électropolissage de la première couche en appliquant, entre une électrode en contact avec la deuxième ou la troisième couche et une contre-électrode disposée dans une solution électrolytique, un courant de polarisation traversant, dans cet ordre, les deuxième, troisième et première couches.

Selon un mode de réalisation, le procédé comprend en outre, postérieurement à l'étape c), une étape de formation, dans et sur l'empilement actif de diode au nitrure de gallium, d'une pluralité de diodes individuelles.

Selon un mode de réalisation, le procédé comprend en outre, entre les étapes b) et c), une étape d) de report de l'empilement actif de diode au nitrure de gallium et de l'empilement d'électropolissage sur un circuit de contrôle.

Selon un mode de réalisation, le procédé comprend en outre, entre les étapes b) et d), une étape de formation, dans et sur l'empilement actif de diode au nitrure de gallium, d'une pluralité de diodes individuelles.

Selon un mode de réalisation, la première couche est située sur et en contact avec une face de la troisième couche opposée au substrat de support.

Selon un mode de réalisation, le procédé comprend en outre, préalablement à l'étape c), une étape de formation de tranchées traversant le substrat de support et formant, en vue de dessus, une grille.

Selon un mode de réalisation, le procédé comprend en outre, postérieurement à la formation des tranchées, une étape de formation de vias localisés aux intersections de la grille, les vias s'étendant à travers les deuxième et troisième couches et s'interrompant dans l'épaisseur de la première couche.

Selon un mode de réalisation, la deuxième couche est située sur et en contact avec une face de la troisième couche opposée au substrat de support.

Selon un mode de réalisation, le procédé comprend en outre, préalablement à l'étape c), une étape de formation de tranchées et/ou de vias traversant le substrat de support et s'interrompant dans l'épaisseur de la première couche.

Selon un mode de réalisation, le procédé comprend en outre, postérieurement à l'étape c), une étape de formation de microlentilles dans les deuxième et troisième couches.

Selon un mode de réalisation, la première couche présente un niveau de dopage au moins dix fois supérieur à celui de la troisième couche.

Selon un mode de réalisation :
- les première et deuxième couches présentent chacune un niveau de dopage égal à environ 1.10¹⁹ at.cm⁻³ ; et
- la troisième couche présente un niveau de dopage égal à environ 1.10¹⁶ at.cm⁻³.

Selon un mode de réalisation, l'empilement actif de diode au nitrure de gallium est un empilement actif de diode électroluminescente au nitrure de gallium.

Selon un mode de réalisation, l'empilement actif de diode au nitrure de gallium est un empilement actif de diode photosensible au nitrure de gallium.

Selon un mode de réalisation, l'empilement d'électropolissage comprend en outre une quatrième couche semiconductrice de transition interposée entre le substrat de support et la première couche.

Selon un mode de réalisation, le procédé comprend en outre, préalablement à l'étape a), une étape de formation, sur le substrat de support, d'un empilement tampon comprenant au moins une couche d'adaptation de paramètre de maille et de coefficient d'expansion thermique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E et la figure 1F sont des vues de côté et en coupe, schématiques et partielles, d'exemples de structures obtenues à l'issue d'étapes successives d'un procédé de réalisation d'un dispositif opto-électronique selon un mode de réalisation ;
la figure 2 est une vue de côté et en coupe, schématique et partielle, d'un exemple de structure obtenue à l'issue d'une étape d'une variante du procédé des figures 1A à 1F ;
la figure 3A, la figure 3B, la figure 3C, la figure 3D, la figure 3E et la figure 3F sont des vues de côté et en coupe, schématiques et partielles, d'exemples de structures obtenues à l'issue d'étapes successives d'un procédé de réalisation d'un dispositif opto-électronique selon un mode de réalisation ;
la figure 4A, la figure 4B et la figure 4C sont des vues de côté et en coupe, schématiques et partielles, d'exemples de structures obtenues à l'issue d'étapes successives d'un procédé de réalisation d'un dispositif opto-électronique selon un mode de réalisation ;
la figure 5 est une vue de dessus, schématique et partielle, de la structure de la figure 1D ; et
la figure 6 est un graphique représentant des variations de taille et de densité de pores à l'intérieur d'une couche en nitrure de gallium en fonction d'un niveau de dopage et d'une tension de polarisation appliquée à ladite couche.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différentes applications des dispositifs opto-électroniques de la présente description, notamment les divers appareils susceptibles d'intégrer de tels dispositifs, n'ont pas été détaillées, les modes de réalisation décrits étant compatibles avec toutes ou la plupart des applications usuelles et avec tous ou la plupart des appareils usuels mettant en œuvre au moins un dispositif opto-électronique, moyennant éventuellement des adaptations à la portée de la personne du métier à la lecture de la présente description.

Par ailleurs, la réalisation d'un circuit intégré de contrôle de diodes au nitrure de gallium n'a pas été détaillée, les modes de réalisation décrits étant compatibles avec les structures et procédés de fabrication usuels de tels circuits de contrôle. De plus, la composition et l'agencement des différentes couches d'un empilement actif de diode au nitrure de gallium n'ont pas été détaillés, les modes de réalisation décrits étant compatibles avec les empilements actifs usuels de diode au nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Sauf précision contraire, les termes « isolant » et « conducteur » signifient respectivement électriquement isolant et électriquement conducteur.

Sauf précision contraire, l'expression « en contact avec » signifie « en contact mécanique avec ».

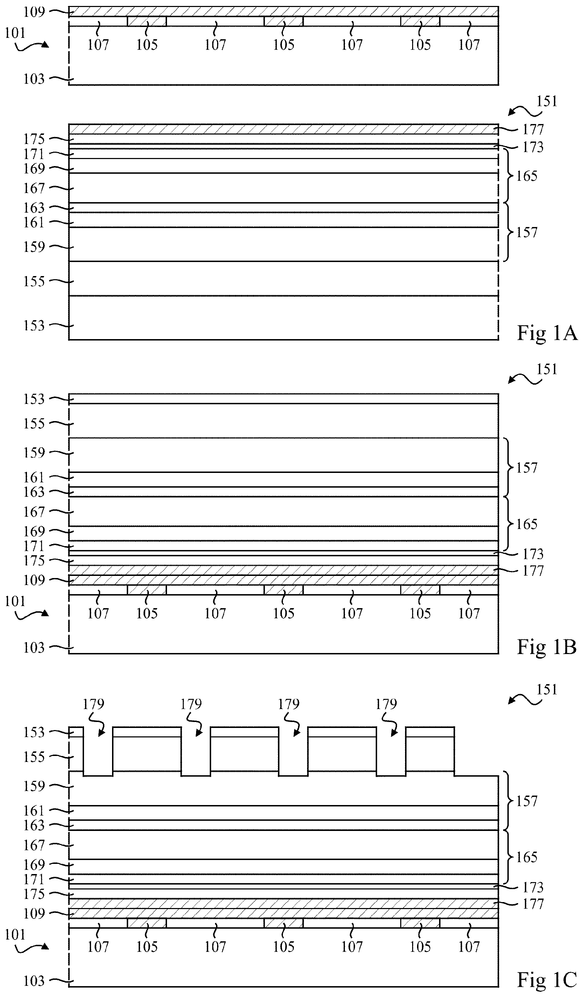

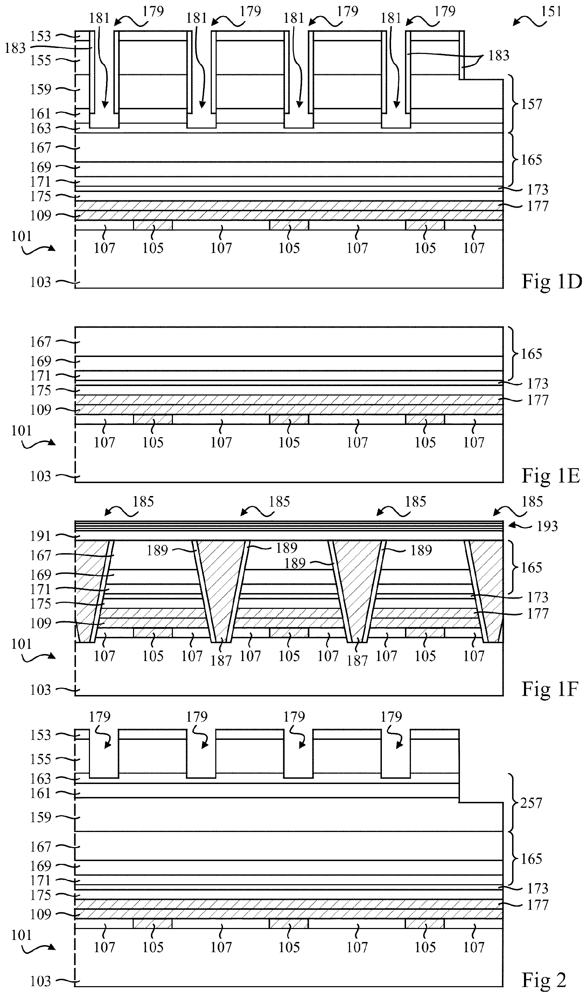

La figure 1A, la figure 1B, la figure 1C, la figure 1D, la figure 1E et la figure 1F sont des vues de côté et en coupe, schématiques et partielles, d'exemples de structures obtenues à l'issue d'étapes successives d'un procédé de réalisation d'un dispositif opto-électronique comportant une pluralité de diodes au nitrure de gallium (GaN) selon un mode de réalisation.

La figure 1A représente, de façon schématique, un circuit intégré de contrôle 101 préalablement formé dans et sur un substrat 103. Le substrat 103 est par exemple une plaquette ou un morceau de plaquette en un matériau semiconducteur, par exemple le silicium.

Dans l'exemple représenté, le circuit de contrôle 101 comprend, du côté de sa face supérieure, pour chacune des diodes du dispositif, un plot métallique de connexion 105 destiné à être connecté à l'une des électrodes (anode ou cathode) de la diode. Dans le cas d'une diode électroluminescente (LED), le plot métallique de connexion 105 permet par exemple de commander un courant circulant dans la LED et/ou d'appliquer une tension aux bornes de la LED. Le circuit de contrôle 101 comprend par exemple, pour chaque LED, une cellule élémentaire de contrôle connectée au plot métallique 105 dédié à la LED et comportant un ou plusieurs transistors permettant de contrôler le courant circulant dans la LED et/ou la tension appliquée aux bornes de la LED. Le circuit de contrôle 101 est par exemple réalisé en technologie CMOS (de l'anglais « Complementary Metal-Oxide-Semiconductor »). À titre d'exemple, le circuit de contrôle est de type ASIC (de l'anglais « Application-Specific Integrated Circuit » - circuit intégré propre à une application).

Les plots métalliques 105 peuvent être entourés latéralement par un matériau isolant 107, par exemple de l'oxyde de silicium, de sorte que le circuit de contrôle 101 présente une face supérieure sensiblement plane comprenant une alternance de régions métalliques 105 et de régions isolantes 107. Le contact sur les électrodes des LEDs (cathodes ou anodes) non connectées aux plots 105 peut être pris de façon collective, par exemple dans une région périphérique du circuit de contrôle 101, par l'intermédiaire d'un ou plusieurs plots de connexion (non visibles sur la figure) du circuit de contrôle 101.

Dans l'exemple représenté, une couche métallique 109 revêt sensiblement toute la face supérieure du circuit de contrôle 101. En particulier, la couche métallique 109 est en contact avec les plots métalliques de connexion 105 du circuit de contrôle 101.

La figure 1A représente en outre, de façon schématique, une structure 151 formée sur un substrat de support 153. Le substrat de support 153 est par exemple une plaquette ou un morceau de plaquette en silicium, en saphir, en corindon, ou en tout autre matériau sur lequel un empilement actif de diode au nitrure de gallium peut être formé.

Dans l'exemple représenté, la structure 151 comprend une couche tampon 155 revêtant la face supérieure du substrat de support 153. Dans l'exemple illustré, la couche tampon 155 est située sur et en contact avec la face supérieure du substrat de support 153. À titre d'exemple, la couche tampon 155 est en nitrure d'aluminium (AlN) ou en nitrure d'aluminium-gallium (AlGaN). La couche tampon 155 présente par exemple une épaisseur de l'ordre de plusieurs centaines de nanomètres. Bien que la figure 1A illustre un exemple dans lequel la structure 151 comporte une seule couche tampon 155, cet exemple n'est pas limitatif et la structure 151 peut, à titre de variante, comporter un nombre quelconque de couches tampon disposées sur la face supérieure du substrat de support 153.

Dans l'exemple illustré, la structure 151 comporte en outre un empilement d'électropolissage 157 situé sur le substrat de support 153. Dans l'exemple représenté, l'empilement d'électropolissage 157 revêt la couche tampon 155.

Dans l'exemple représenté, l'empilement d'électropolissage 157 comprend :
- une couche 159 de transport de charges située sur et en contact avec la face supérieure de la couche tampon 155 ;
- une couche 161 de protection de la couche 159 située sur et en contact avec la face supérieure de la couche 159 ; et
- une couche 163 sacrificielle située sur et en contact avec la face supérieure de la couche 161.

Chaque couche 159, 161, 163 est par exemple à base d'un matériau semiconducteur, par exemple le GaN.

La couche 159 est par exemple en GaN fortement dopé de type n (n-GaN). À titre d'exemple, la couche 159 présente un niveau de dopage égal à environ 1.10¹⁹ at.cm⁻³. La couche 159 présente par exemple une épaisseur égale à environ 1 µm.

La couche 161 est par exemple en GaN intrinsèque, c'est-à-dire en GaN non intentionnellement dopé (GaN UID, de l'anglais « unintentionally doped » ou GaN NID, de l'anglais « Non-Intentionally Doped »). À titre d'exemple, la couche 161 présente une concentration en donneurs résiduels comprise entre 10¹⁵ et 10¹⁸ at.cm⁻³, par exemple de l'ordre de 10¹⁷ at.cm⁻³. La couche 161 présente par exemple une épaisseur comprise dans une plage allant de 200 à 500 nm.

La couche 163 est par exemple en GaN fortement dopé de type n. À titre d'exemple, la couche 159 présente un niveau de dopage inférieur ou égal à celui de la couche 163. Le niveau de dopage de la couche 163 est en particulier très supérieur, par exemple au moins dix fois supérieur, à celui de la couche 161. La couche 163 présente par exemple un niveau de dopage égal à environ 1.10¹⁹ at.cm⁻³. La couche 163 présente une épaisseur strictement inférieure à celle de la couche 159, par exemple de l'ordre de quelques dizaines ou quelques centaines de nanomètres. À titre d'exemple, l'épaisseur de la couche 163 est comprise dans une plage allant de 20 à 500 nm.

Bien que cela n'ait pas été illustré en figure 1A, l'empilement d'électropolissage 157 peut en outre comporter une couche de transition interposée entre la couche tampon 155 et la couche 159 de transport de charges. Dans ce cas, la couche de transition présente par exemple une structure multicouche comprenant une couche en GaN dopé au carbone (GaN:C) revêtant la couche tampon 155 et une autre couche en GaN UID revêtant la couche en GaN:C. À titre d'exemple, la couche en GaN:C présente un niveau de dopage de l'ordre de 10¹⁸ at.cm⁻³. La couche en GaN:C présente par exemple une épaisseur comprise dans une plage allant de 100 à 500 nm. À titre d'exemple, la couche en GaN UID présente un niveau de dopage de l'ordre de 1.10¹⁶ at.cm⁻³. La couche en GaN UID présente par exemple une épaisseur comprise dans une plage allant de 100 à 500 nm. La couche de transition permet par exemple de réduire la rugosité de surface avant croissance de la couche 159. Elle permet par exemple en outre de gérer les contraintes présentes dans la couche 159.

Dans l'exemple représenté, la structure 151 comprend en outre un empilement actif de diode 165 au GaN, par exemple un empilement actif de LED au GaN, disposé au-dessus du substrat de support 153, sur l'empilement d'électropolissage 157. Dans l'exemple représenté, l'empilement actif 165 comprend, dans l'ordre depuis la face supérieure de l'empilement d'électropolissage 157, une couche de nitrure de gallium dopé de type n 167, une couche active 169 - par exemple une couche émissive, dans le cas d'un empilement actif de LED - et une couche de nitrure de gallium dopé de type p 171. La couche active 169 est par exemple constituée par un empilement d'une ou plusieurs couches actives formant chacune un puits quantique, par exemple à base de GaN, InN, InGaN, AlGaN, AlN, AlInGaN, GaP, AlGaP, AlInGaP, ou d'une combinaison d'un ou plusieurs de ces matériaux. À titre de variante, la couche active 169 peut être une couche de nitrure de gallium intrinsèque, présentant par exemple une concentration en donneurs résiduels comprise entre 10¹⁵ et 10¹⁸ at.cm⁻³, par exemple de l'ordre de 10¹⁷ at.cm⁻³.

Dans l'exemple représenté, la face inférieure de la couche active 169 est en contact avec la face supérieure de la couche 167, et la face supérieure de la couche active 169 est en contact avec la face inférieure de la couche 171.

Dans l'exemple illustré, la couche tampon 155 permet de faire interface entre le substrat de support 153 et la couche de nitrure de gallium 167. Bien que cela n'ait pas été illustré, d'autres couches tampon peuvent être prévues entre le substrat de support 153 et l'empilement actif de diode 165. Les couches 167, 169 et 171 de l'empilement actif de diode 165 sont par exemple formées par épitaxie depuis la face supérieure de l'empilement d'électropolissage 157, la couche tampon 155 permettant alors de réaliser une adaptation de paramètre de maille et de coefficient d'expansion thermique entre le substrat de support 153 et l'empilement actif de diode 165.

Dans l'exemple illustré en figure 1A, la structure 151 comprend en outre une couche conductrice transparente 173 revêtant l'empilement actif de diode 165. Dans l'exemple représenté, la couche conductrice 173 est située sur et en contact avec la face supérieure de la couche 171. La couche conductrice 173 fait par exemple office d'électrode supérieure en contact avec la couche 171 dopée de type p.

Dans l'exemple représenté, la structure 151 comprend en outre une couche miroir 175 revêtant la couche conductrice 173. Dans l'exemple illustré, la couche miroir 175 est située sur et en contact avec la face supérieure de la couche conductrice 173. La couche miroir est par exemple une couche métallique réfléchissante dans une plage de longueurs d'onde d'émission de l'empilement actif de diode 165, dans le cas où l'empilement 165 est un empilement actif de LED.

Par ailleurs, dans cet exemple, la structure 151 comprend une couche métallique 177 revêtant la couche miroir 175. La couche métallique 177 est par exemple située sur et en contact avec la face supérieure de la couche miroir 175. La couche métallique 177 revêt par exemple sensiblement toute la face supérieure de l'empilement actif 165. À titre d'exemple, la couche métallique 177 est en le même matériau que la couche métallique 109.

La figure 1B représente une structure obtenue à l'issue d'une étape ultérieure de report de l'empilement actif 165 de diode au GaN et de l'empilement d'électropolissage 157 sur la face supérieure du circuit de contrôle 101. Pour cela, l'ensemble comprenant le substrat de support 153 et la structure 151 est par exemple retourné puis rapporté sur le circuit de contrôle 101, de façon à mettre la face supérieure (dans l'orientation de la figure 1A) de la couche métallique 177 en contact avec la face supérieure de la couche métallique 109. Au cours de cette étape, l'empilement actif 165 est fixé au circuit de contrôle 101. À titre d'exemple, la fixation de l'empilement actif 165 sur le circuit de contrôle 101 peut être obtenue par collage moléculaire entre les deux surfaces mises en contact. À titre de variante, la fixation des deux surfaces peut être réalisée par thermocompression, collage hybride, ou par toute autre méthode de fixation adaptée.

La figure 1B illustre en outre une étape ultérieure d'amincissement du substrat de support 153, par exemple par meulage (« grinding », en anglais). Dans l'exemple représenté, une partie du substrat de support 153 subsiste sur la face supérieure de la couche tampon 155 à l'issue de cette étape. Cet exemple n'est toutefois pas limitatif, le substrat de support 153 pouvant, à titre de variante, être totalement retiré au cours de cette étape.

La figure 1C représente une structure obtenue à l'issue d'une étape ultérieure de formation de tranchées 179 du côté de la face supérieure de la structure de la figure 1B.

Dans l'exemple représenté, les tranchées s'étendent verticalement, depuis une face du substrat de support 153 opposée à l'empilement actif de diode 165 (la face supérieure du substrat de support 153, dans l'orientation de la figure 1C), à travers le substrat de support 153 et la couche tampon 155, et s'interrompent dans l'épaisseur de la couche 159. Les tranchées 179 sont par exemple agencées de sorte à présenter, en vue de dessus, la forme d'une grille.

Dans l'exemple illustré, des parties du substrat de support 153 et la couche tampon 155 sont en outre retirées dans une région périphérique de la structure (à droite de la structure, dans l'orientation de la figure 1C). Cette région présente par exemple la forme d'une couronne, dans le cas où le substrat 103 est une plaquette de forme sensiblement circulaire.

À titre de variante, la formation des tranchées 179 peut être omise, et seules les parties du substrat de support 153 et de la couche tampon de la région périphérique de la structure sont retirées. Cela permet d'accéder à la face supérieure de la couche 159 de manière à réaliser un contact électrique situé en bord de plaque.

La figure 1D représente une structure obtenue à l'issue d'une étape ultérieure de formation de vias 181 depuis la face supérieure de la structure de la figure 1C.

Dans l'exemple représenté, les vias 181 s'étendent verticalement, à travers les couches 159 et 161 de l'empilement d'électropolissage 157, et s'interrompent dans l'épaisseur de la couche 163. Les vias 181 sont par exemple localisés aux intersections de la grille formée par les tranchées 179.

Dans l'exemple illustré, les parois des vias 181 sont au moins partiellement revêtues d'une couche isolante 183. La couche isolante 183 revêt par exemple totalement les faces latérales de la couche 159 exposées à l'intérieur de chaque tranchée 179 et de chaque via 181. Cela permet de passiver la couche 159 en vue d'une étape ultérieure d'électropolissage de la couche sacrificielle 163. La couche isolante 183 revêt par exemple en outre intégralement les faces latérales du substrat de support 153 et de la couche tampon 155, et revêt par exemple partiellement les faces latérales de la couche 161 exposées à l'intérieur de chaque tranchée 179 et de chaque via 181. Dans l'exemple représenté, la couche isolante 183 ne revêt pas le fond des vias 181. À titre de variante, la couche isolante 183 peut être omise, par exemple dans un cas où la couche sacrificielle 163 présente un niveau de dopage au moins dix fois supérieur à celui de la couche 159.

La figure 1E représente une structure obtenue à l'issue d'une étape ultérieure de retrait du substrat de support 153, de la couche tampon 155 et de l'empilement 157 par électropolissage de la couche sacrificielle 163.

Pour cela, la structure de la figure 1D est par exemple plongée dans un bain contenant une solution électrolytique et un potentiel est par exemple appliqué entre une électrode en contact avec la couche 159, par exemple située dans la région périphérique de la structure, et une contre-électrode plongée dans la solution électrolytique. L'électrode en contact avec la couche 159 est par exemple située sur et en contact avec une partie de la face supérieure de la couche 159 non revêtue de la couche 155 (du côté droit de la structure, dans l'orientation de la figure 1D). À titre de variante, l'électrode est en contact avec la couche 161, l'électrode étant par exemple alors située sur et en contact avec une partie de la face supérieure de la couche 161 non revêtue de la couche 159. Par ailleurs, la contre-électrode est par exemple située au-dessus de la structure de la figure 1D. La solution électrolytique dans laquelle est plongée la structure pénètre dans les tranchées 179 et dans les vias 181. Cela permet de mettre la solution électrolytique en contact avec la couche 163.

Lors de l'application du potentiel, un courant de polarisation circulant depuis l'électrode en contact avec la couche 159 ou 161 vers la contre-électrode traverse, dans cet ordre, la couche 159, la couche 161 et la couche 163. Le courant de polarisation provoque un retrait de la couche sacrificielle 163 par électropolissage. Cela conduit à dissocier l'empilement actif de diode 165 de la couche tampon 155 revêtant le substrat de support 153.

Au cours de cette étape, la couche isolante 183 permet d'éviter que la solution électrolytique ne vienne en contact avec la couche 159 à l'intérieur des vias 181.

La figure 1F représente une structure obtenue à l'issue d'une étape ultérieure de formation d'éléments de reprise de contact 185.

Dans l'exemple représenté, chaque élément de reprise de contact 185 comprend une région conductrice 187 dont les flancs sont revêtus d'une couche isolante 189. Dans l'orientation de la figure 1F, chaque région conductrice 187 s'étend verticalement depuis la face supérieure de l'empilement actif de diode 165, à travers les couches 167, 169, 171, 173, 175, 177 et 109 et à travers les régions isolantes 107, jusque dans le circuit de contrôle 101. La région conductrice 187 est par exemple en contact électrique avec des niveaux métalliques inférieurs du circuit de contrôle (non représentés), afin d'assurer une connexion électrique de la cathode de la LED associée.

La figure 1F illustre en outre une étape ultérieure de dépôt d'une couche conductrice transparente 191 et d'une structure réfléchissante 193 du côté de la face supérieure de la structure. Dans l'exemple représenté, la couche conductrice 191 est située sur et en contact avec la face supérieure de la couche 167 et avec les faces supérieures des régions conductrices 187 des éléments de reprise de contact 185. La couche 191 constitue par exemple une électrode de cathode commune aux diodes du dispositif.

À titre d'exemple, la structure réfléchissante 193 est un réseau de Bragg, ou réflecteur de Bragg distribué (« Distributed Bragg Reflector » - DBR, en anglais).

La figure 2 est une vue de côté et en coupe, schématique et partielle, d'un exemple de structure obtenue à l'issue d'une étape d'une variante du procédé des figures 1A à 1F.

La structure de la figure 2 présente des éléments en commun avec la structure de la figure 1C. Ces éléments communs ne seront pas détaillés à nouveau ci-après. La structure de la figure 2 diffère de celle de la figure 1C en ce qu'elle comprend un empilement d'électropolissage 257 analogue à l'empilement d'électropolissage 157 de la figure 1C mais dans lequel l'ordre des couches 159, 161 et 163 est inversé. Plus précisément, dans l'orientation de la figure 2, la couche 159 est située sur et en contact avec la face supérieure de la couche 167 de l'empilement actif de diode 165 et la couche 163 est située sous et en contact avec la face inférieure de la couche tampon 155, la couche 161 étant interposée entre les couches 159 et 163.

La structure de la figure 2 est par exemple obtenue par la mise en œuvre d'étapes analogues à celles précédemment décrites en relation avec les figures 1A et 1C en remplaçant l'empilement d'électropolissage 157 par l'empilement d'électropolissage 257. Des étapes analogues à celles précédemment décrites en relation avec les figures 1D à 1F sont par exemple ensuite mises en œuvre à partir de la structure de la figure 2. En particulier, des vias analogues aux vias 181 peuvent être réalisés dans la structure de la figure 2 aux intersections de la grille formée par les tranchées 179. À titre de variante, les vias 181 peuvent être omis. À titre de variante, seuls des vias 181 peuvent être réalisés, les tranchées 179 étant alors omises.

Dans cette variante, la couche isolante 183 est par exemple omise.

Des procédés de réalisation de dispositifs opto-électroniques dans lesquels les diodes individuelles sont formées après report de l'empilement actif de diode sur le circuit de contrôle ont été décrits en relation avec les figures 1A à 1F et la figure 2. À titre de variante, les diodes individuelles peuvent être formées avant report de l'empilement actif de diode sur le circuit de contrôle, par exemple comme cela est décrit ci-dessous.

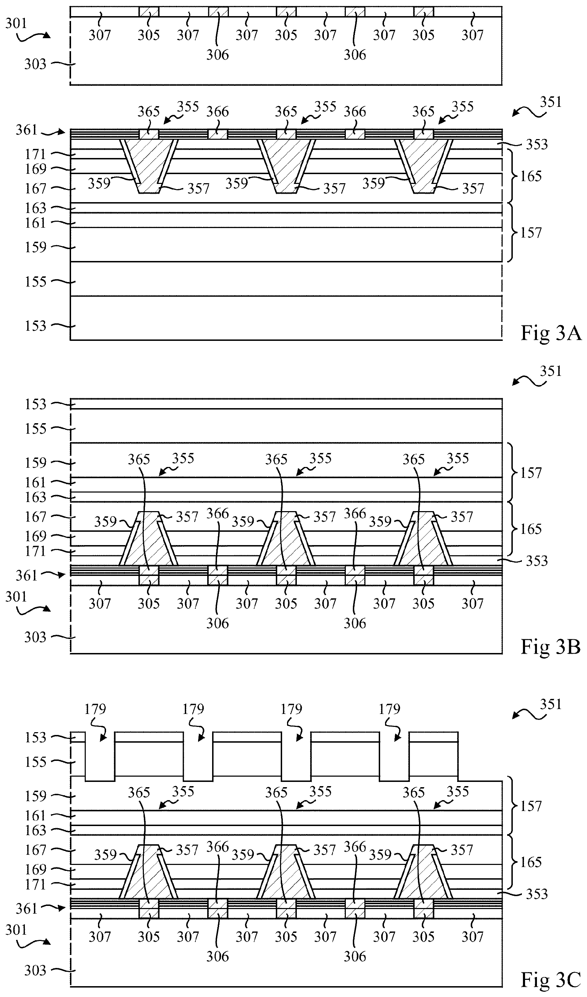

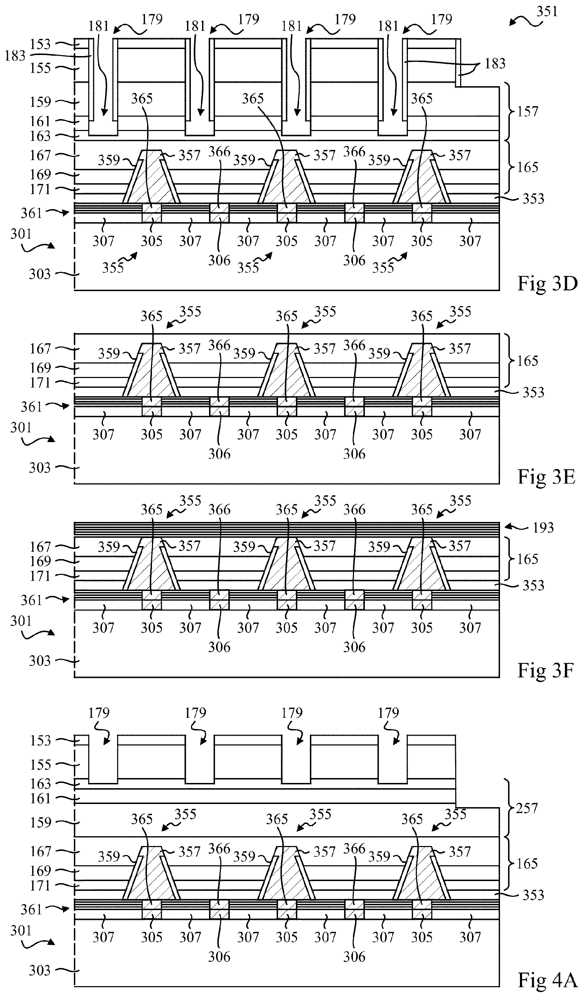

La figure 3A, la figure 3B, la figure 3C, la figure 3D, la figure 3E et la figure 3F sont des vues de côté et en coupe, schématiques et partielles, d'exemples de structures obtenues à l'issue d'étapes successives d'un procédé de réalisation d'un dispositif opto-électronique selon un mode de réalisation.

La figure 3A représente, de façon schématique, un circuit intégré de contrôle 301 préalablement formé dans et sur un substrat 303. Le substrat 303 est par exemple analogue ou identique au substrat 103 précédemment décrit en relation avec la figure 1A. Dans l'exemple représenté, le circuit de contrôle 301 comprend, du côté de sa face supérieure, pour chacune des diodes du dispositif, un plot métallique de connexion 305 destiné à être connecté à l'une des électrodes (anode ou cathode) de la diode et un autre plot métallique de connexion 306 destiné à être connecté à l'autre électrode de la diode. Dans le cas d'une diode électroluminescente (LED), les plots métalliques de connexion 305 et 306 permettent par exemple de commander un courant circulant dans la LED et/ou d'appliquer une tension aux bornes de la LED. Le circuit de contrôle 301 comprend par exemple, pour chaque LED, une cellule élémentaire de contrôle connectée aux plots métalliques 305 et 306 dédiés à la LED et comportant un ou plusieurs transistors permettant de contrôler le courant circulant dans la LED et/ou la tension appliquée aux bornes de la LED. Le circuit de contrôle 301 est par exemple réalisé en technologie CMOS. Les plots métalliques 305 et 306 peuvent être entourés latéralement par un matériau isolant 307, par exemple de l'oxyde de silicium, de sorte que le circuit de contrôle 301 présente une face supérieure sensiblement plane comprenant une alternance de régions métalliques 305, 306 et de régions isolantes 307.

Dans l'exemple représenté, contrairement au circuit de contrôle 101 de la figure 1A, le circuit de contrôle 301 est dépourvu de couche métallique revêtant sa face supérieure.

La figure 3A représente en outre, de façon schématique, une structure 351 formée sur le substrat de support 153 précédemment décrit en relation avec la figure 1A.

La structure 351 de la figure 3A comprend des éléments en commun avec la structure 151 de la figure 1A. Ces éléments communs ne seront pas détaillés à nouveau ci-après.

La structure 351 de la figure 3A diffère de la structure 151 de la figure 1A en ce que la structure 351 comprend, outre la couche tampon 155, l'empilement d'électropolissage 157 et l'empilement actif de diode 165, une couche conductrice transparente 353 revêtant la face supérieure de la couche 171. La couche conductrice transparente 353 est par exemple analogue ou identique à la couche conductrice transparente 191 précédemment décrite en relation avec la figure 1F.

Dans l'exemple représenté, la structure 351 comprend en outre des éléments de reprise de contact 355 affleurant la face supérieure de la couche conductrice 353.

Dans l'exemple illustré, chaque élément de reprise de contact 355 comprend une région conductrice 357 dont les flancs sont revêtus d'une couche isolante 359. Dans l'orientation de la figure 3A, chaque région conductrice 357 s'étend verticalement depuis la face supérieure de la couche conductrice 353, à travers les couches 353, 171 et 169 et s'interrompt dans l'épaisseur de la couche 167.

Dans l'exemple représenté, la structure 351 comprend en outre une structure réfléchissante 361 revêtant la face supérieure de la couche conductrice 353 et les faces supérieures des éléments de reprise de contact 355. À titre d'exemple, la structure réfléchissante 361 est analogue ou identique à la structure réfléchissante 193 précédemment décrite en relation avec la figure 1F.

Dans l'exemple illustré, la structure 351 comprend en outre des plots métalliques de connexion 365 et 366 formés dans la structure réfléchissante 193. Chaque plot métallique de connexion 365 est en contact, par sa face inférieure, avec la face supérieure de la région conductrice 357 de l'élément de reprise de contact 355 sous-jacent. Par ailleurs, chaque plot métallique de connexion 366 est en contact, par sa face inférieure, avec la face supérieure de la couche conductrice 353. Les plots métalliques de connexion 365 et 366 de la structure 351 sont destinés à être mis en contact avec les plots métalliques 305 et 306, respectivement, du circuit de contrôle 301. Dans l'exemple représenté, les plots métalliques 365 et 366 constituent respectivement des contacts de cathode et d'anode des diodes.

La figure 3B représente une structure obtenue à l'issue d'une étape ultérieure de report de l'empilement actif 165 de diode au GaN et de l'empilement d'électropolissage 157 sur la face supérieure du circuit de contrôle 301. Pour cela, l'ensemble comprenant le substrat de support 153 et la structure 351 est par exemple retourné puis rapporté sur le circuit de contrôle 301, de façon à mettre les faces supérieures (dans l'orientation de la figure 3A) des plots de connexion métalliques 365 et 366 avec les faces supérieures des plots de connexion métalliques 305 et 306, respectivement. Au cours de cette étape, l'empilement actif 165 est fixé au circuit de contrôle 301. À titre d'exemple, la fixation de l'empilement actif 165 sur le circuit de contrôle 301 peut être obtenue par collage moléculaire entre les deux surfaces mises en contact. À titre de variante, la fixation des deux surfaces peut être réalisée par thermocompression, collage hybride, ou par toute autre méthode de fixation adaptée.

La figure 3B illustre en outre une étape ultérieure d'amincissement du substrat de support 153, par exemple par meulage (« grinding », en anglais). Dans l'exemple représenté, une partie du substrat de support 153 subsiste sur la face supérieure de la couche tampon 155 à l'issue de cette étape. Cet exemple n'est toutefois pas limitatif, le substrat de support 153 pouvant, à titre de variante, être totalement retiré lors de cette étape.

La figure 3C représente une structure obtenue à l'issue d'une étape ultérieure de formation des tranchées 179 du côté de la face supérieure de la structure de la figure 3B, par exemple de manière analogue à ce qui a été exposé précédemment en relation avec la figure 1C.

La figure 3D représente une structure obtenue à l'issue d'une étape ultérieure de formation des vias 181 depuis la face supérieure de la structure de la figure 3C et de formation de la couche isolante 183, par exemple de manière analogue à ce qui a été exposé précédemment en relation avec la figure 1D.

La figure 3E représente une structure obtenue à l'issue d'une étape ultérieure de retrait du substrat de support 153, de la couche tampon 155 et de l'empilement 157 par électropolissage de la couche sacrificielle 163, par exemple de manière analogue à ce qui a été décrit ci-dessus en relation avec la figure 1E.

La figure 3F représente une structure obtenue à l'issue d'une étape ultérieure d'amincissement de la couche 167 de sorte que les régions conductrices 357 des éléments de reprise de contact 355 affleurent la face supérieure de la couche 167. En outre, au cours de cette étape, la structure réfléchissante 193 est déposée du côté de la face supérieure de la couche 167.

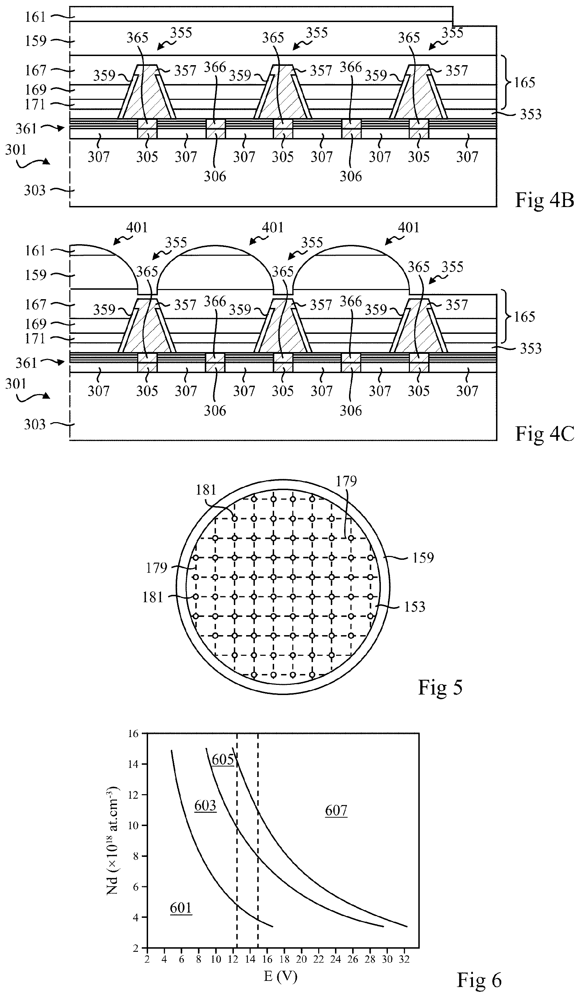

La figure 4A, la figure 4B et la figure 4C sont des vues de côté et en coupe, schématiques et partielles, d'exemples de structures obtenues à l'issue d'étapes successives d'un procédé de réalisation d'un dispositif opto-électronique selon un mode de réalisation.

La figure 4A est une vue de côté et en coupe, schématique et partielle, d'un exemple de structure obtenue à l'issue d'une étape d'une variante du procédé des figures 3A à 3F.

La structure de la figure 4A présente des éléments en commun avec la structure de la figure 3C. Ces éléments communs ne seront pas détaillés à nouveau ci-après. La structure de la figure 4A diffère de celle de la figure 3C en ce qu'elle comprend, à la place de l'empilement d'électropolissage 157, l'empilement d'électropolissage 257 décrit ci-dessus en relation avec la figure 2. Plus précisément, dans l'orientation de la figure 4A, la couche 159 est située sur et en contact avec la face supérieure de la couche 167 de l'empilement actif de diode 165 et la couche 163 est située sous et en contact avec la face inférieure de la couche tampon 155, la couche 161 étant interposée entre les couches 159 et 163.

La structure de la figure 4A est par exemple obtenue par la mise en œuvre d'étapes analogues à celles précédemment décrites en relation avec les figures 3A et 3C en remplaçant l'empilement d'électropolissage 157 par l'empilement d'électropolissage 257.

La figure 4B représente une structure obtenue à l'issue d'une étape ultérieure de retrait du substrat de support 153 et des couches 155 et 163 par électropolissage de la couche sacrificielle 163, par exemple de manière analogue à ce qui a été décrit ci-dessus en relation avec la figure 1E.

La figure 4C représente une structure obtenue à l'issue d'une étape ultérieure de formation de microlentilles 401 dans les couches 159 et 161 de l'empilement d'électropolissage 257 subsistant à l'issue du retrait de la couche sacrificielle 163.

Dans l'exemple représenté, les microlentilles 401 sont formées à l'aplomb de parties de la couche active 169 situées en vis-à-vis des plots métalliques de connexion 366.

La figure 5 est une vue de dessus, schématique et partielle, de la structure de la figure 1D.

Dans l'exemple représenté, des lignes verticales et horizontales en pointillé symbolisent les tranchées 179 s'étendant depuis la face supérieure du substrat de support 153 et formant une grille, et des cercles pleins symbolisent les vias 181 situés sensiblement aux intersections des tranchées 179.

La couronne périphérique formée par la partie de la couche 159 non revêtue permet par exemple la mise en contact d'une électrode destinée à appliquer le potentiel de polarisation servant à éliminer la couche sacrificielle 163 par électropolissage.

La figure 6 est un graphique représentant des variations de taille et de densité de pores à l'intérieur d'une couche en GaN, par exemple la couche sacrificielle 163, en fonction d'un niveau de dopage Nd (exprimé en atomes par centimètre cube, at.cm⁻³, les valeurs indiquées en ordonnée étant à multiplier par 10¹⁸) et d'une tension de polarisation E (en volts, V) appliquée à ladite couche.

Dans l'exemple représenté, le graphique comprend :
- une région 601 de pré-rupture (« pre-breakdown », en anglais) dans laquelle la structure cristalline de la couche commence à se dégrader au niveau des défauts présents dans cette structure ;
- une région 603 de porosification, dans laquelle des pores se forment à l'intérieur de la couche sans toutefois que ces pores ne diminuent sensiblement la cohésion mécanique de la couche ;
- une région 605 de limite d'électropolissage, dans laquelle un début de dégradation de la cohésion mécanique de la couche par regroupement de pores adjacents est observé ; et
- une région 607 d'électropolissage, dans laquelle la couche est retirée, ou gravée, sous l'effet de l'application de la tension de polarisation E.

Dans le cas où la couche sacrificielle 163 est en GaN, un niveau de dopage Nd supérieur ou égal à environ 1,1.10¹⁹ at.cm⁻³ et une tension E appliquée à la couche 163 comprise dans une plage allant de 12 à 14 V permettent par exemple de mettre en œuvre les étapes d'électropolissage de la couche sacrificielle 163 précédemment décrites en relation avec les figures 1E, 3E et 4B. Dans ce cas, la couche 161 de protection présente par exemple un niveau de dopage inférieur ou égal à environ 4.10¹⁸ at. cm⁻³, ce qui permet à la couche 161 de rester dans la région 601 de pré-rupture.

L'épaisseur de la couche sacrificielle 163 est choisie la plus faible possible, de sorte que l'électropolissage, donc le retrait, de cette couche soit le plus rapide possible, tout en étant suffisamment épaisse pour permettre la gravure des vias 181 et/ou des tranchées 179, de sorte que ces vias et/ou ces tranchées débouchent dans la couche 163.

L'épaisseur de la couche 161 de protection est choisie de sorte que la couche 161 soit suffisamment mince pour permettre un bon transfert de charges depuis la couche 159 de transport de charges, et suffisamment épaisse pour demeurer intègre lors de l'étape d'électropolissage de la couche sacrificielle 163.

L'épaisseur de la couche 159 de transport de charges est choisie de sorte que la couche 159 soit suffisamment mince pour ne pas dégrader la qualité cristalline des couches de l'empilement actif 165, et suffisamment épaisse pour demeurer intègre lors de l'étape d'électropolissage de la couche sacrificielle 163, pour éviter des effets de bord dans le cas où le substrat de support 153 présente un diamètre supérieur ou égal à 200 mm, et pour permettre une bonne conduction des charges.

Un avantage des modes de réalisation décrits ci-dessus est qu'ils permettent un meilleur contrôle de l'épaisseur des couches 167, 169 et 171 de l'empilement actif de diode 165 par rapport aux procédés existants de réalisation de dispositifs opto-électroniques comportant une pluralité de diodes au nitrure de gallium et un circuit de contrôle de ces diodes. Cela permet par exemple de réaliser des cavités optiques favorables à la fabrication de dispositifs de type LED à cavité résonnante (« Resonant-Cavity LED » - RC LED, en anglais) ou de type VCSEL (de l'anglais « Vertical-Cavity Surface-Emitting Laser » - diode laser à cavité verticale émettant par la surface).

En outre, un avantage des modes de réalisation de la présente description est qu'ils permettent de simplifier l'opération de retrait du substrat de support sur lequel est formé l'empilement actif de diode 165 ou les diodes individuelles, selon l'approche retenue.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. Par ailleurs, bien que les modes de réalisation décrits ci-dessus prennent pour exemple le cas où l'empilement actif de diode 165 est un empilement actif de LED, ces modes de réalisation sont transposables par la personne du métier à des cas où l'empilement actif de diode est de type quelconque, par exemple un empilement actif de diode photosensible, par exemple un empilement de photodiode à base de GaN. Dans ce cas, les plots métalliques 365 et 366 constituent respectivement des contacts d'anode et de cathode des photodiodes.

Enfin, la mise en œuvre pratique des modes de réalisation et variantes décrits est à la portée de la personne du métier à partir des indications fonctionnelles données ci-dessus. En particulier, la personne du métier est capable, à partir des indications de la présente description, de choisir d'utiliser l'empilement d'électropolissage 157 ou l'empilement d'électropolissage 257, par exemple en fonction de l'épaisseur résiduelle de GaN souhaitée. En particulier, l'empilement d'électropolissage 157 est préféré lorsque l'on souhaite réaliser des composants présentant une faible épaisseur de GaN résiduelle bien maîtrisée, typiquement inférieure à 1 µm, de préférence inférieure à 500 nm, comme c'est le cas dans les structures de type RC-LED décrites en relation avec les figures 1F et 3F ou dans des structures de type VCSEL. Au contraire, lorsque l'on souhaite réaliser des dispositifs présentant une forte épaisseur résiduelle de GaN, typiquement supérieure à 1 µm, de préférence supérieure à 2 µm, le choix de l'empilement d'électropolissage 257 est privilégié. Les épaisseurs de couches 159 et 161 permettent d'affiner les valeurs d'épaisseurs cibles.

Par ailleurs, les modes de réalisation décrits ne se limitent pas aux exemples particuliers de matériaux et de dimensions mentionnés dans la présente description.

## Revendications

1. Procédé de réalisation d'un dispositif opto-électronique, le procédé comprenant les étapes successives suivantes :
a) former, sur un substrat de support (153), un empilement d'électropolissage (157 ; 257) comprenant :
- une première couche (163) semiconductrice sacrificielle ;
- une deuxième couche (159) semiconductrice de transport de charges ; et
- une troisième couche (161) semiconductrice de protection de la deuxième couche (159), la troisième couche (161) étant interposée entre les première (163) et deuxième (159) couches et présentant un niveau de dopage strictement inférieur à ceux des première (163) et deuxième (159) couches ;
b) former, du côté d'une face de l'empilement d'électropolissage (157 ; 257) opposée au substrat de support (153), un empilement actif (165) de diode au nitrure de gallium ; et
c) retirer le substrat de support (153) par électropolissage de la première couche (163) en appliquant, entre une électrode en contact mécanique avec la deuxième (159) ou la troisième (161) couche et une contre-électrode disposée dans une solution électrolytique, un courant de polarisation traversant, dans cet ordre, les deuxième (159), troisième (161) et première (163) couches.

2. Procédé selon la revendication 1, comprenant en outre, postérieurement à l'étape c), une étape de formation, dans et sur l'empilement actif (165) de diode au nitrure de gallium, d'une pluralité de diodes individuelles.

3. Procédé selon la revendication 1, comprenant en outre, entre les étapes b) et c), une étape d) de report de l'empilement actif (165) de diode au nitrure de gallium et de l'empilement d'électropolissage (157 ; 257) sur un circuit de contrôle (101 ; 301).

4. Procédé selon la revendication 3, comprenant en outre, entre les étapes b) et d), une étape de formation, dans et sur l'empilement actif (165) de diode au nitrure de gallium, d'une pluralité de diodes individuelles.

5. Procédé selon l'une quelconque des revendications 1 à 4, dans lequel la première couche (163) est située sur et en contact avec une face de la troisième couche (161) opposée au substrat de support (153).

6. Procédé selon la revendication 5, comprenant en outre, préalablement à l'étape c), une étape de formation de tranchées (179) traversant le substrat de support (153) et formant, en vue de dessus, une grille.

7. Procédé selon la revendication 6, comprenant en outre, postérieurement à la formation des tranchées (179), une étape de formation de vias (181) localisés aux intersections de la grille, les vias (181) s'étendant à travers les deuxième (159) et troisième (161) couches et s'interrompant dans l'épaisseur de la première couche (163).

8. Procédé selon l'une quelconque des revendications 1 à 4, dans lequel la deuxième couche (159) est située sur et en contact avec une face de la troisième couche (161) opposée au substrat de support (153).

9. Procédé selon la revendication 8, comprenant en outre, préalablement à l'étape c), une étape de formation de tranchées (179) et/ou de vias (181) traversant le substrat de support (153) et s'interrompant dans l'épaisseur de la première couche (163).

10. Procédé selon la revendication 8 ou 9, comprenant en outre, postérieurement à l'étape c), une étape de formation de microlentilles (401) dans les deuxième (159) et troisième (161) couches.

11. Procédé selon l'une quelconque des revendications 1 à 10, dans lequel la première couche (163) présente un niveau de dopage au moins dix fois supérieur à celui de la troisième couche (161).

12. Procédé selon la revendication 11, dans lequel :
- les première (163) et deuxième (159) couches présentent chacune un niveau de dopage égal à 1.10¹⁹ at.cm⁻³, à 10 % près, de préférence à 5 % près ; et
- la troisième couche (161) présente un niveau de dopage égal à 1.10¹⁶ at.cm⁻³, à 10 % près, de préférence à 5 % près.

13. Procédé selon l'une quelconque des revendications 1 à 12, dans lequel l'empilement actif (165) de diode au nitrure de gallium est un empilement actif de diode électroluminescente au nitrure de gallium.

14. Procédé selon l'une quelconque des revendications 1 à 12, dans lequel l'empilement actif (165) de diode au nitrure de gallium est un empilement actif de diode photosensible au nitrure de gallium.

15. Procédé selon l'une quelconque des revendications 1 à 14, dans lequel l'empilement d'électropolissage (157 ; 257) comprend en outre une quatrième couche semiconductrice de transition interposée entre le substrat de support (153) et la première couche (163).

16. Procédé selon l'une quelconque des revendications 1 à 15, comprenant en outre, préalablement à l'étape a), une étape de formation, sur le substrat de support (153), d'un empilement tampon comprenant au moins une couche (155) d'adaptation de paramètre de maille et de coefficient d'expansion thermique.
